# EUROPEAN PATENT APPLICATION

(11) **EP 2 192 598 A1**
(43) Date of publication of application: **02.06.2010**
(21) Application number: 09011520.5
(22) Date of filing: 08.09.2009
(51) Int. Cl.: H01B 1/22, H05K 1/09, H05K 3/10, H05K 3/12

(54) **Paste composition for forming heat-resistant conductive patterns on substrate**

(30) Priority: 01.12.2008 KR 20080120347; 17.06.2009 KR 20090053873
(71) Applicant: Exax Inc., Gumi-si, Kyungsangbuk-do 730-906 (KR)
(72) Inventor: Heo, Soon Yeong, Cheonan-si Chungcheongnam-do (KR); Park, Seong Sil, Cheonan-si Chungcheongnam-do (KR)
(74) Representative: advotec.

(57) **Abstract**

The present invention provides a paste composition for forming heat-resistant and electrically conductive patterns on substrate by direct printing comprising conductive particles, polyamic acid and solvent.

The paste composition according to the present invention can form solderable electric circuits or solderable antenna on substrate, especially on flexible sheets by direct printing while to simplify processes, to save time and cost, and to minimize waste.

## Description

### DETAILED DESCRIPTION

### TECHNICAL FIELD

The present invention is directed to a paste composition for forming heat-resistant conductive patterns on substrate, especially for forming heat-resistant conductive patterns solderable for components on substrate by direct printing to produce printed circuit boards (PCB) or flexible printed circuit boards (FPCB).

### TECHNICAL BACKGROUND

A PCB or a FPCB is the most basic electronic component with various components soldered or mounted on to function a device. A PCB or a FPCB is manufactured to have certain patterns or circuits by etching a copper clad laminate (CCL) or a flexible copper clad laminate (FCCL) respectively. A method of patterning through etching is called a "subtractive method".

On the other hand, researches and efforts have been made to apply an additive method by direct printing for relatively simple pattern forming in displays including a liquid crystal display (LCD) and a plasma display panel (PDP), touch panels, RFID, shields against electromagnetic waves and so on instead of a subtractive method by etching which causes complexities in processes and a great quantity of waste to be treated after processes. To enlarge the scope of the above-mentioned efforts, manufacturing economically PCB or FPCB by printing directly conductive patterns on a board has been attempted to avoid complexities and waste problems of subtractive methods. However, since on PCB or FPCB is mounted or soldered many components, manufacture of PCB or FPCB by direct printing still has many problems to overcome such as heat-resistance, adhesive strength and solderabilty besides conductivity.

### DISCLOSURE

### TECHNICAL PROBLEM

An object of the present invention is to provide a paste composition for forming electrically conductive patterns having heat resistance on substrate by direct printing.

Another object of the present invention is to provide a paste composition for forming electrically conductive circuits solderable to manufacture FPCB.

The other object of the present invention is to provide a paste composition for forming antenna bondable with Rfid chip.

### TECHNICAL SOLUTION

According to the present invention, there is provided a paste composition for forming electrically conductive patterns by direct printing comprising conductive particles, polyamic acid and solvent. The paste composition preferably consists of 0.01 to 96 w% of conductive particles, 0.5 to 96 w% of polyamic acid and residual solvent. The paste composition, if necessary, may further comprise a metal precursor. The polyamic acid is preferably defined as Formula 1 below. 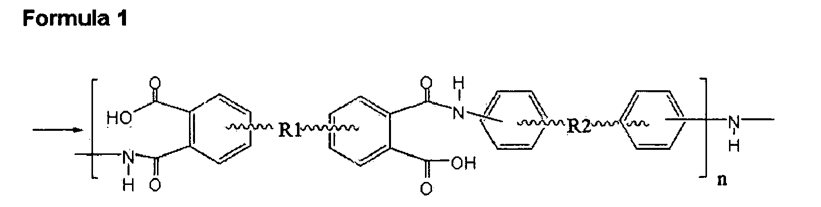 R1 and R2 are respectively a hydrocarbon chain or a hetero-atomic chain having N, O and/or S, or indicate a bridge or fusion between benzene rings. R1 and R2 are, for example, respectively CO-, -SO₂-, -CH₂-, -C₂H₄-, -C₃H₆- or -O- .

The polyamic acid is obtained by polyaddition of aromatic diacid anhydride defined as formula 2 below and aromatic diamine defmed as formula 3 below. As a solvent, for example, N,N-dimethylformamide("DMF"), N,N-dimethylacetamide("DMAc"), N-methylpyrrolidone("NMP"), tetramethylurea("TMU"), dimethylsulfoxide("DMSO") or mixture thereof is used to dissolve or to disperse the aromatic diacid anhydride and/or the aromatic diamine. In the present invention, "solvent" means broadly medium inclusive of solvent and dispersion medium and "solution" is used to include dispersion as a case may be. The polyamic acid binder is prepared by mixing a solution of the aromatic diacid anhydride and a solution of the aromatic diamine. The solvent for the solution of the aromatic diacid anhydride is preferably the same as that of the aromatic diamine and imported as solvent for the resultant binder without separation. 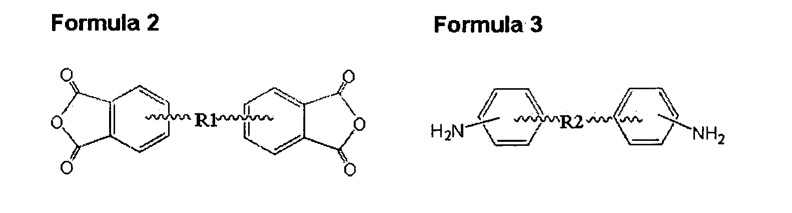 R1 and R2 are respectively a hydrocarbon chain or a hetero-atomic chain having N, O and/or S, or indicate a bridge or fusion between benzene rings.

The aromatic diacid anhydride defined as formula 2 above is, for example, 1,2,4,5-benzentetracarboxylic dianhydride, 3,3',4,4'-benzophenonetetracarboxylic dianhydride ("BTDA"), oxydiphthalic anhydride("ODPA"), 3,3',4,4'-diphenylsulfonetetracarboxylic anhydride("DSDA"), biphenyltetracarboxylic dianhydride("BPDA"), 3-hydroquinone-o,o' -diacetic anhydride("HQDA") or 2,2-bis[4-3,4-dicarboxyphenoxylphenyl]propane dianhydride("BPADA").

The aromatic diamine defmed as formula 3 above is, for example, m-phenylenediamine, p-phenylenediamine, oxydianiline, 4,4'-diaminodiphenylsulfone or 4, 4'-diaminobenzophenone.

Herein, "conductive particles" mean particles of electrically conductive material. The material has no limitation as long as it has electric conductivity as solid state. The material is metal or nonmetal, oxides, carbides, borides, nitrides or carbonitrides thereof inclusive of carboneous particle such as carbon black and graphite. Conductive particles are, for example, particles of gold, aluminum, copper, indium, antimony, magnesium, chrome, tin, nickel, silver, iron, titanium and alloys thereof, and oxides, carbides, borides, nitrides and carbonitrides thereof. As carboneous particles, there are, for example, natural graphite flake, expanded graphite, graphene, carbon black, nano-carbon and carbon nanotube. The shape of particles, not specially restricted, is, for example, plain, fibrous or nano-sized. Such particles may be used solely or in combination.

Herein, metal precursor means organo-metallic compound wherein metal is bonded to organic material through hetero atoms such as P, S, O and N and which is metalized at temperatures much lower than the melting point of the corresponding metal. Such organo-metal includes, for example, metal bonded to a ketone, a mercapto, a carboxyl, an aniline, an ether or a thiosulfate group.

Direct printing includes brushing, spraying, roller coating, screen printing, gravure printing, offset printing, flexography, dispensing, rotary screen printing and inkjet printing.

Besides stiff boards, various flexible substrate such as paper, polyester film and polyimide film can be used in the present invention.

The paste according to the present invention is printed on substrate as a pattern and dried at a higher or an ambient temperature, and then is baked or heat-treated between 150 °C to 350 °C to imidize the polyamic acid. Heat-treating for metallization can be carried out separately from or simultaneously with that for the imidization in the range of the temperature, when metal precursor is used in the paste. The paste is fixed on the substrate since metal precursor is metalized and polyamic acid binder is ring-closed through such heat-treating. The imidized binder resists above 400 °C.

The paste composition according to the present invention can form electrically conductive patterns on which components are mounted by soldering. Such conductive patterns are used as electric circuits as it is, but can be electro-plated to strengthen conductivity, solderability and adhesive force.

The conductive patterns formed by the paste composition according to the present invention include electric circuits, electrodes, Rfid antenna and partial or total coating.

### ADVANTAGEOUS EFFECT

The paste composition according to the present invention can form solderable electric circuits or solderable antenna on substrate, especially on flexible sheet by direct printing while to simplify processes, to save time and cost, and to minimize waste.

### DESCRIPTION OF DRAWINGS

Figure 1 is a photograph showing a pattern formed and electro-plated in Example 1.
Figure 2 is a photograph showing a pattern formed and electro-plate in Example 2.
Figure 3 is a photograph showing soldering on the pattern formed and electro-plate in Example 1.

### MODE FOR INVENTION

Hereinafter, examples are described in detail, but the scope of the present invention should not be construed to be limited by the examples. Various alternatives or modifications would be possible while they would be within the scope of the present invention.

### Examples 1 to 7

### Reparation of binder

19.2 g of 4, 4'-diaminodiphenyl ether("ODA") is dissolved in 80g of N-methylpyrrolidone to prepare ODA solution. 20.9 g of pyromellitic dianhydride ("PMDA") is dispersed in 80g of N-methylpyrrolidone to prepare PMDA dispersion. The PMDA dispersion is added dropwise to the ODA solution for 2 hours. The mixture is reacted for 24 hours by agitating at room temperature to prepare polyamic acid binder.

### Preparation of paste and Printing

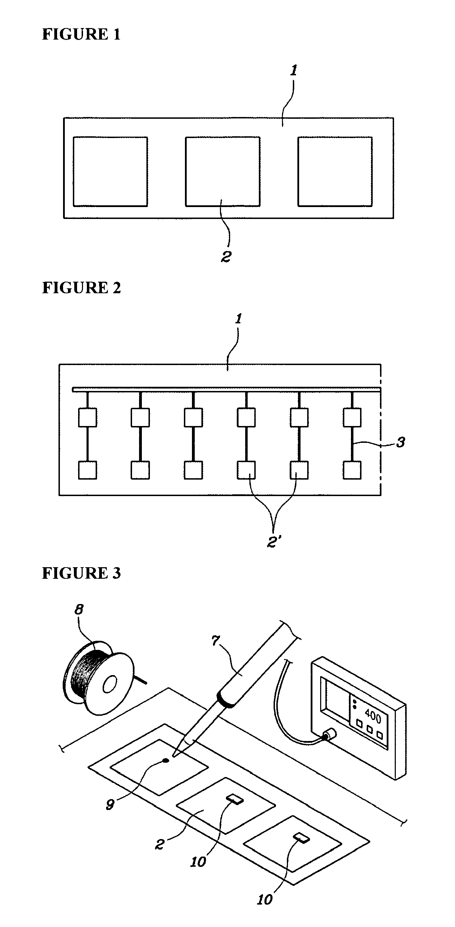

150 to 210 g of plate-like(the diameter is 50 times of the thickness) silver powder having an average particle size of 2 µm, 0 to 30 g of N-methylpyrrolidone and 6 to 150 g of the polyamic acid binder prepared above are thoroughly mixed together according to the proportions as shown in Table 1 to prepare silver pastes. On polyimide film, a pattern is printed as shown in Figure 1 by a screen printer using the silver pastes as ink. The printing including the film is baked for about 10 minutes at 200 °C to get rid of volatile organic compounds. Surface resistance, adhesion, hardness and stability under heat of the pattern formed were measured and indicated Table 2. The surface resistances according to Examples were indicated as a graph in Table 3. Surface resistance is measured by 4-probe method, adhesion force by tape method(ASTM-D3359B ) and hardness by pencil-hardness-test(ASTM-D3369). Stability under heat for pastes is rated by observing melting and deformation under heating and soldering as follows:
⊚; excellent, no deformation when touched for I minute with iron heated at 400 °C
○; good, no deformation after soldering with iron
△; ordinary, no deformation after 30 minutes in a oven sustaining at 280 °C, but deformation after soldering with iron
x; deformation after 30 minutes in a oven sustaining at 280 °C

### Electroplating

Circuits of 0.5 mm×1 mm dimension are printed on polyimide film and baked. The circuits were further electro-plated. Multilayer ceramic condenser was soldered on the circuit by an iron at 400 °C. The adhesion was measured as peel strength using a tensile strength tester. The results are shown Table4.

**Table 1**

| Example | Paste No. | PAA Binder(g) | NMP(g) | Ag powder(g) |
|---|---|---|---|---|
| 1 | AP-A | 60 | 30 | 210 |
| 2 | AP-B | 75 | 15 | 210 |
| 3 | AP-C | 90 | - | 210 |
| 4 | AP-D | 105 | - | 195 |
| 5 | AP-E | 120 | - | 180 |
| 6 | AP-F | 135 | - | 165 |
| 7 | AP-G | 150 | - | 150 |

**Table 2**

| Example | Paste No. | Surface Resistance (×10⁻² Ω/□) | Adhesion Test | Hardness | Stability under Heat |
|---|---|---|---|---|---|
| 1 | AP-A | 4.094 | 5B | 5H | ○ |
| 2 | AP-B | 3.428 | 5B | 5H | ○ |
| 3 | AP-C | 2.287 | 5B | 5H | ⊚ |
| 4 | AP-D | 3.512 | 5B | 5H | ⊚ |
| 5 | AP-E | 5.254 | 5B | 5H | ⊚ |
| 6 | AP-F | 7.882 | 5B | 5H | ⊚ |
| 7 | AP-G | 9.883 | 5B | 5H | ⊚ |

| | | | | | |
|---|---|---|---|---|---|
| ⊚ very excellent, ○ excellent, △ ordinary, × bad | | | | | |

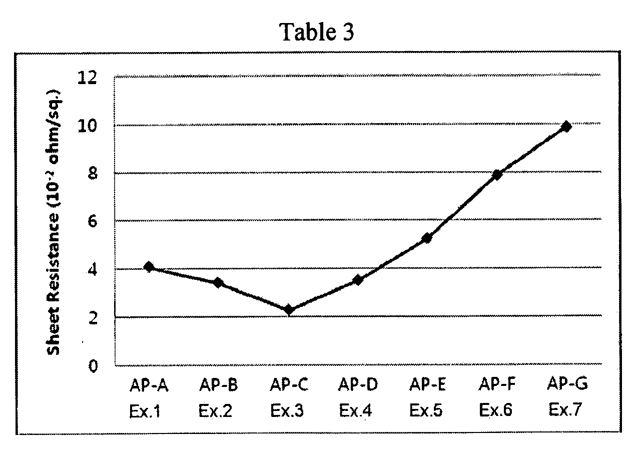

**Table 4**

| Example | Paste No. | Adhesion Test | Hardness | Peel Strength(g_{f}) |
|---|---|---|---|---|
| 1 | AP-A | 5B | 5H | 630 |
| 2 | AP-B | 5B | 5H | 650 |
| 3 | AP-C | 5B | 5H | 742 |
| 4 | AP-D | 5B | 5H | 853 |
| 5 | AP-E | 5B | 5H | 901 |
| 6 | AP-F | 5B | 5H | 934 |
| 7 | AP-G | 5B | 5H | 980 |

### Examples 8-19

### Preparation of binder

71.75g of 4,4'-diaminodiphenyl ether("ODA") is dissolved in 300g of N-methylpyrrolidone to prepare ODA solution. 78.24 g of pyromellitic dianhydride ("PMDA") is dispersed in 300g of N-methylpyrrolidone to prepare PMDA dispersion. The PMDA dispersion is added dropwise to the ODA solution for 2 hours. The mixture is reacted for 18 hours by agitating at room temperature to prepare polyamic acid("PAA") binder.

### Preparation of paste and Printing

93.75 to 112.5 g of plate-like(the diameter is 50 times of the thickness) silver powder having an average particle size of 2 µm, 0 to 18.75 g of N-methylpyrrolidone and 37.5 to 52.5 g of the polyamic acid binder prepared above are thoroughly mixed together according to the proportions as shown in Table 5 to prepare silver pastes. On polyimide film, a pattern is printed as shown in Figure 1 by a screen printer using the silver pastes as ink. The printing including the film is baked for about 10 minutes at 200 °C to get rid of volatile organic compounds. Surface resistance, adhesive force, hardness and stability under heat of the pattern formed were measured and indicated Table 6. The surface resistances according to Examples were indicated as a graph in Table 7.

**Table 5**

| Example | Paste No. | PAA Binder(g) | NMP(g) | Ag powder(g) |
|---|---|---|---|---|
| 8 | PA-A1 | 37.5 | 18.75 | 93.75 |
| 9 | PA-B1 | 45 | 11.25 | 93.75 |
| 10 | PA-C1 | 52.5 | 3.75 | 93.75 |
| 11 | PA-A2 | 37.5 | 15 | 97.5 |
| 12 | PA-B2 | 45 | 7.5 | 97.5 |
| 13 | PA-C2 | 52.5 | 3 | 94.5 |
| 14 | PA-A3 | 37.5 | 11.25 | 101.25 |
| 15 | PA-B3 | 45 | 3.75 | 101.25 |
| 16 | PA-C3 | 52.5 | 2.25 | 95.25 |
| 17 | PA-A4 | 37.5 | - | 112.5 |
| 18 | PA-B4 | 45 | - | 105 |
| 19 | PA-C4 | 52.5 | - | 97.5 |

**Table 6**

| Example | Paste No. | thickness(um) | Surface Resistance (×10⁻² Ω/□) | Adhesion Test | Hardness | Stability under Heat |
|---|---|---|---|---|---|---|
| 8 | PA-A1 | 7 | 4.677 | 5B | 5H | ⊚ |
| 9 | PA-B1 | 8 | 4.129 | 5B | 5H | ⊚ |
| 10 | PA-C1 | 9 | 4.119 | 5B | 5H | ⊚ |
| 11 | PA-A2 | 12 | 3.204 | 5B | 5H | ⊚ |
| 12 | PA-B2 | 11 | 2.798 | 5B | 5H | ⊚ |
| 13 | PA-C2 | 9 | 4.498 | 5B | 5H | ⊚ |
| 14 | PA-A3 | 13 | 3.440 | 5B | 5H | ⊚ |
| 15 | PA-B3 | 14 | 3.083 | 5B | 5H | ⊚ |
| 16 | PA-C3 | 11 | 2.993 | 5B | 5H | ⊚ |
| 17 | PA-A4 | 17 | 2.730 | 5B | 5H | ⊚ |
| 18 | PA-B4 | 19 | 2.381 | 5B | 5H | ⊚ |
| 19 | PA-C4 | 12 | 3.310 | 5B | 5H | ⊚ |

| | | | | | | |
|---|---|---|---|---|---|---|
| ⊚ very excellent, ○ excellent, △ ordinary, × bad | | | | | | |

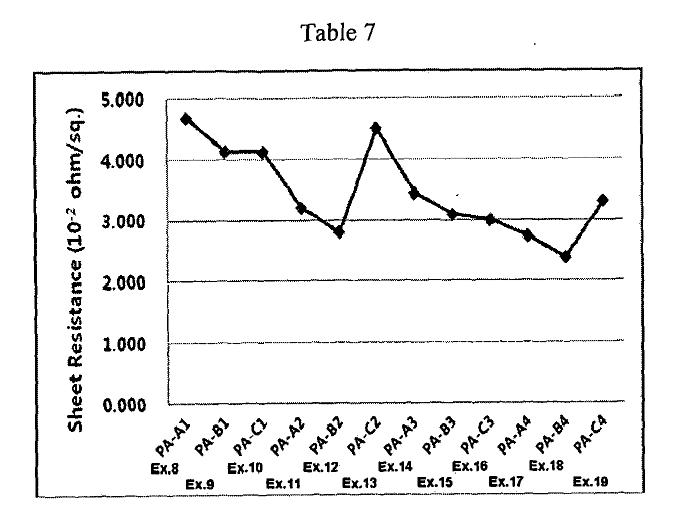

### Examples 20-31

Examples 20-31 are carried out the same way as Example 8 except that dimethylacetamide ("DMAc") is used as solvent instead of N-methylpyrrolidone for preparation of PAA binder. The constituents and their proportions of the silver pastes prepared are indicated in Table 8. Baking of printings and measuring method for surface resistance, adhesive force, hardness and stability under heat are the same as Example 8. The resultant values of measurements are indicated in Table 9. The surface resistances according to Examples were indicated as a graph in Table 10.

**Table 8**

| Example | Paste No. | PAA Binder(g) | DMAc(g) | Ag powder(g) |
|---|---|---|---|---|
| 20 | PA-J1 | 37.5 | 18.75 | 93.75 |
| 21 | PA-K2 | 45 | 11.25 | 93.75 |
| 22 | PA-L3 | 52.5 | 3.75 | 93.75 |
| 23 | PA-J2 | 37.5 | 15 | 97.5 |
| 24 | PA-K2 | 45 | 7.5 | 97.5 |
| 25 | PA-L2 | 52.5 | 3 | 94.5 |
| 26 | PA-J3 | 37.5 | 11.25 | 101.25 |
| 27 | PA-K3 | 45 | 3.75 | 101.25 |
| 28 | PA-L3 | 52.5 | 2.25 | 95.25 |
| 29 | PA-J4 | 37.5 | - | 112.5 |
| 30 | PA-B4 | 45 | - | 105 |
| 31 | PA-L4 | 52.5 | - | 97.5 |

**Table 9**

| Example | Paste No. | thickness(um) | Surface Resistance (×10⁻² Ω/□) | Adhesion Test | Hardness | Stability under Heat |
|---|---|---|---|---|---|---|
| 20 | PA-J1 | 8 | 4.203 | 5B | 5H | ⊚ |
| 21 | PA-K1 | 8 | 3.642 | 5B | 5H | ⊚ |
| 22 | PA-L1 | 7 | 1.832 | 5B | 5H | ⊚ |
| 23 | PA-J2 | 8 | 4.064 | 5B | 5H | ⊚ |
| 24 | PA-K2 | 10 | 2.621 | 5B | 5H | ⊚ |
| 25 | PA-L2 | 12 | 2.025 | 5B | 5H | ⊚ |
| 26 | PA-J3 | 11 | 3.778 | 5B | 5H | ⊚ |
| 27 | PA-K3 | 14 | 2.255 | 5B | 5H | ⊚ |
| 28 | PA-L3 | 12 | 2.320 | 5B | 5H | ⊚ |
| 29 | PA-J4 | 19 | 2.513 | 5B | 5H | ⊚ |
| 30 | PA-K4 | 13 | 2.140 | 5B | 5H | ⊚ |
| 31 | PA-L4 | 13 | 4.368 | 5B | 5H | ⊚ |

| | | | | | | |
|---|---|---|---|---|---|---|
| ⊚ very excellent, ○ excellent, △ ordinary, × bad | | | | | | |

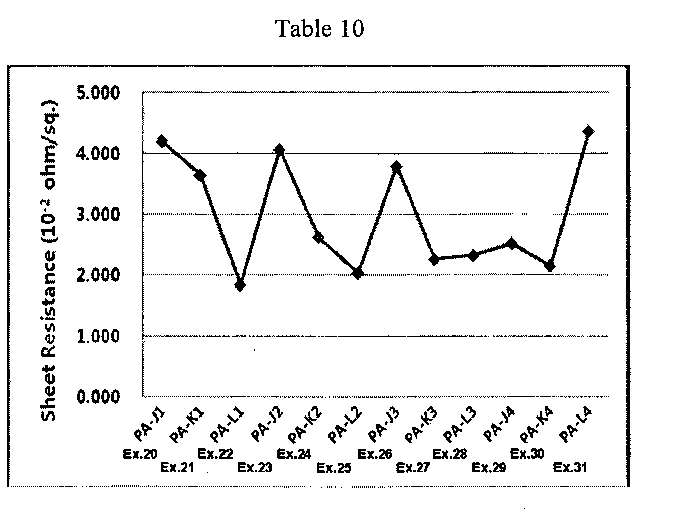

### Examples 32-34

Examples 32-34 are carried out the same way as Example 8 except that dimethylformamide ("DMF") is used as solvent instead of N-methylpyrrolidone for preparation of PAA binder. The constituents and their proportions of the silver pastes prepared are indicated in Table 11. Baking of printings and measuring method for surface resistance, adhesive force, hardness and stability under heat are the same as Example 8. The resultant values of measurements are indicated in Table 12. The surface resistances according to Examples were indicated as a graph in Table 13.

**Table 11**

| Example | Paste No. | PAA Binder(g) | DMF(g) | Ag powder(g) |
|---|---|---|---|---|
| 32 | PA-G | 37.5 | 18.75 | 93.75 |
| 33 | PA-H | 45 | 11.25 | 93.75 |
| 34 | PA-I | 52.5 | 3.75 | 93.75 |

**Table 12**

| Example | Paste No. | thickness(um) | Surface Resistance (×10⁻² Ω/□) | Adhesion Test | Hardness | Stability under Heat |
|---|---|---|---|---|---|---|
| 32 | PA-G | 8 | 5.901 | 5B | 5H | ⊚ |
| 33 | PA-H | 9 | 4.875 | 5B | 5H | ⊚ |
| 34 | PA-I | 7 | 3.012 | 5B | 5H | ⊚ |

| | | | | | | |
|---|---|---|---|---|---|---|
| ⊚ very excellent, ○ excellent, △ ordinary, × bad | | | | | | |

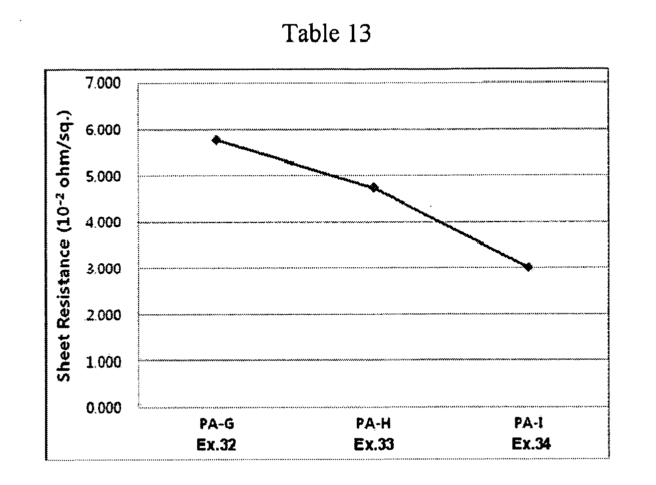

### Examples 35-37

Examples 35-37 are carried out the same way as Example 8 except that dimethylsulfoxide ("DMSO") is used as solvent instead of N-methylpyrrolidone for preparation of PAA binder. The constituents and their proportions of the silver pastes prepared are indicated in Table 14. Baking of printings and measuring method for surface resistance, adhesive force, hardness and stability under heat are the same as Example 8. The resultant values of measurements are indicated in Table 15. The surface resistances according to Examples were indicated as a graph in Table 16.

**Table 14**

| Example | Paste No. | PAA Binder(g) | DMSO(g) | Ag powder(g) |
|---|---|---|---|---|
| 35 | PA-J | 37.5 | 18.75 | 93.75 |
| 36 | PA-K | 45 | 11.25 | 93.75 |
| 37 | PA-L | 52.5 | 3.75 | 93.75 |

**Table 15**

| Example | Paste No. | thickness(u m) | Surface Resistance (×10⁻² Ω/□) | Adhesion Test | Hardness | Stability under Heat |
|---|---|---|---|---|---|---|
| 35 | PA-J | 11 | 5.214 | 5B | 5H | ⊚ |
| 36 | PA-K | 13 | 4.504 | 5B | 5H | ⊚ |
| 37 | PA-L | 12 | 4.349 | 5B | 5H | ⊚ |

| | | | | | | |
|---|---|---|---|---|---|---|
| ⊚ very excellent, ○ excellent, △ ordinary, × bad | | | | | | |

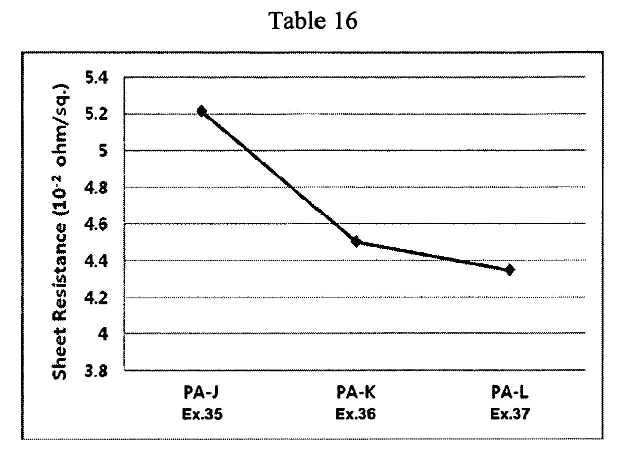

### Examples 38-41

Examples 38-41 are carried out the same way as Example 8 except that 60.293g of 4,4'-diaminodiphenyl ether("ODA") and 59.7g of pyromellitic dianhydride ("PMDA") dimethylsulfoxide ("DMSO") are used to be in equivalent ratio of 1.1:1 for preparation of PAA binder. The constituents and their proportions of the silver pastes prepared are indicated in Table 17. Baking of printings and measuring method for surface resistance, adhesive force, hardness and stability under heat are the same as Example 8. The resultant values of measurements are indicated in Table 18. The surface resistances according to Examples were indicated as a graph in Table 19.

**Table 17**

| Example | Paste No. | PAA Binder(g) | NMP(g) | Ag powder(g) |
|---|---|---|---|---|
| 38 | PA-M | 30 | 26.25 | 93.75 |
| 39 | PA-N | 37.5 | 18.75 | 93.75 |
| 40 | PA-O | 45 | 11.25 | 93.75 |
| 41 | PA-P | 52.5 | 3.75 | 93.75 |

**Table 18**

| Example | Paste No. | thickness(um) | Surface Resistance (×10⁻² Ω/□) | Adhesion Test | Hardness | Stability under Heat |
|---|---|---|---|---|---|---|
| 38 | PA-M | 8 | 5.193 | 5B | 5H | ⊚ |
| 39 | PA-N | 8 | 3.582 | 5B | 5H | ⊚ |
| 40 | PA-O | 9 | 2.441 | 5B | 5H | ⊚ |
| 41 | PA-P | 10 | 2.232 | 5B | 5H | ⊚ |

| | | | | | | |
|---|---|---|---|---|---|---|
| ⊚ very excellent, ○ excellent, △ ordinary, × bad | | | | | | |

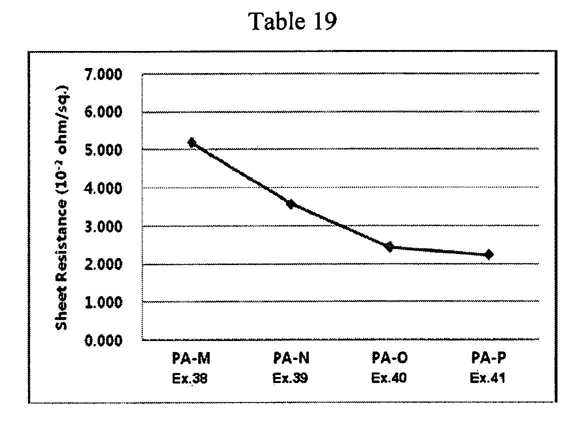

### Examples 42-45

Examples 42-45 are carried out the same way as Example 8 except that 63.15g of 4,4'-diaminodiphenyl ether("ODA") and 56.85g of pyromellitic dianhydride ("PMDA") dimethylsulfoxide ("DMSO") are used to be in equivalent ratio of 1.2:1 for preparation of PAA binder. The constituents and their proportions of the silver pastes prepared are indicated in Table 20. Baking of printings and measuring method for surface resistance, adhesive force, hardness and stability under heat are the same as Example 8. The resultant values of measurements are indicated in Table 21. The surface resistances according to Examples were indicated as a graph in Table 22.

**Table 20**

| Example | Paste No. | PAA Binder(g) | NMP(g) | Ag powder(g) |
|---|---|---|---|---|
| 42 | PA-Q | 30 | 26.25 | 93.75 |
| 43 | PA-R | 37.5 | 18.75 | 93.75 |
| 44 | PA-S | 45 | 11.25 | 93.75 |
| 45 | PA-T | 52.5 | 3.75 | 93.75 |

**Table 21**

| Example | Paste No. | thickness(u m) | Surface Resistance (×10⁻² Ω/□) | Adhesion Test | Hardness | Stability under Heat |
|---|---|---|---|---|---|---|
| 42 | PA-Q | 9 | 5.666 | 5B | 5H | ⊚ |
| 43 | PA-R | 8 | 4.129 | 5B | 5H | ⊚ |
| 44 | PA-S | 9 | 2.828 | 5B | 5H | ⊚ |
| 45 | PA-T | 10 | 2.529 | 5B | 5H | ⊚ |

| | | | | | | |
|---|---|---|---|---|---|---|
| ⊚ very excellent, ○ excellent, △ ordinary, × bad | | | | | | |

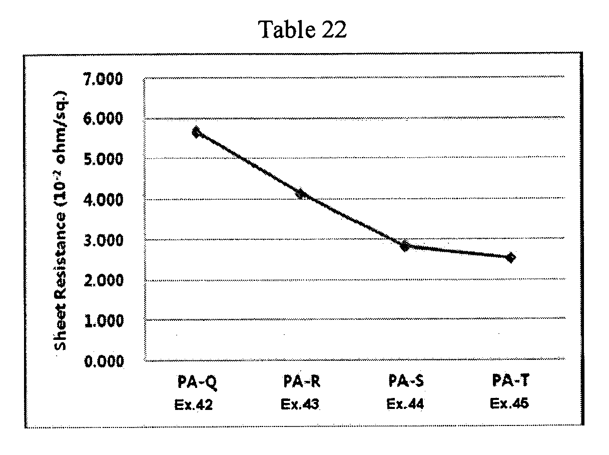

## Claims

1. A paste composition for forming heat-resistant and electrically conductive patterns by direct printing comprising conductive particles, polyamic acid and solvent.

2. The paste composition according to Claim 1, wherein the polyamic acid is defmed as Formula 1 as below 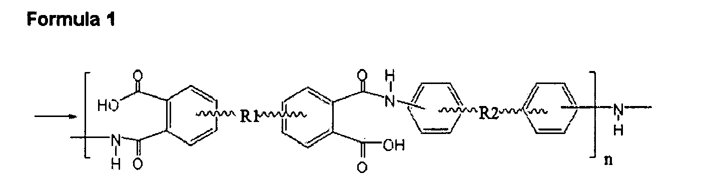 R1 and R2 respectively is a hydrocarbon chain or a hetero-atomic chain having N, O and/or S, or indicate a bridge or fusion between benzene rings.

3. The paste composition according to Claim 2, wherein the polyamic acid are prepared by polyaddition of aromatic diacid anhydride defined as formula 2 below and aromatic diamine defined as formula 3 below 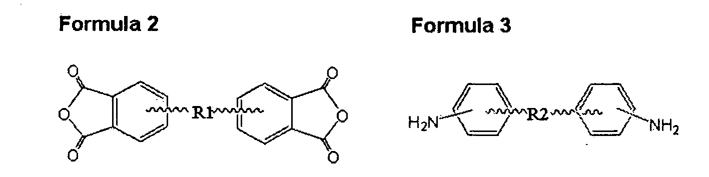 R1 and R2 respectively is a hydrocarbon chain or a hetero-atomic chain having N, O and/or S, or indicate a bridge or fusion between benzene rings.

4. The paste composition according to Claim 3, wherein the aromatic diacid anhydride defmed is 1,2,4,5-benzentetracarboxylic dianhydride, 3,3', 4,4'-benzophenonetetracarboxylic dianhydride ("BTDA"), oxydiphthalic anhydride("ODPA"), 3,3', 4,4'-diphenylsulfonetetracarboxylic anhydride("DSDA"), biphenyltetracarboxylic dianhydride("BPDA"), 3-hydroquinone-o,o' -diacetic anhydride("HQDA") or 2,2-bis[4-3,4-dicarboxyphenoxylphenyl]propane dianhydride("BPADA"); and the aromatic diamine is m-phenylenediamine, p-phenylenediamine, oxydianyline, 4,4'-diaminodiphenylsulfone or 4,4'-diaminobenzophenone.

5. The paste composition according to Claim 3, wherein the solvent or the medium for the polyamic acid, the aromatic diacid anhydride and the aromatic diamine is selected from the group consisting of N,N-dimethylformamide, N,N-dimethylacetamide, N-methylpyrrolidone, tetramethylurea, dimethylsulfoxide and mixture thereof.

6. The paste composition according to Claim 3, wherein the conductive particles are particles of electrically conductive material selected from the group consisting of metal, nonmetal, oxides, carbides, borides, nitrides, carbonitrides and carboneous material.

7. The paste composition according to Claim 1, wherein the substrate is paper, polyester film or polyimide film.

8. The paste composition according to Claim 1, wherein the direct printing is brushing, spraying, roller coating, screen printing, gravure printing, offset printing, flexography, dispensing, rotary screen printing or inkjet printing.

9. The paste composition according to Claim 1, wherein the conductive patterns are Rfid antenna.
